# EUROPEAN PATENT SPECIFICATION

(11) **EP 4 081 009 B1**
(45) Date of publication and mention of the grant of the patent: **02.08.2023**
(21) Application number: 21170225.3
(22) Date of filing: 23.04.2021
(51) Int. Cl.: H05K 9/00

(54) **ELECTRICAL ASSEMBLY FOR ELECTROMAGNETIC SHIELDING**
ELEKTRISCHE ANORDNUNG ZUR ELEKTROMAGNETISCHEN ABSCHIRMUNG
ENSEMBLE ÉLECTRIQUE POUR BLINDAGE ÉLECTROMAGNÉTIQUE

(43) Date of publication of application: 26.10.2022
(73) Proprietor: Valeo eAutomotive France SAS, 95800 Cergy (FR)
(72) Inventor: SORSDAHL, Torbjorn, 3036 Drammen (NO)
(74) Representative: Valeo Powertrain Systems

(56) References cited:
- US-A1- 2004 264 155
- US-A1- 2014 080 355

## Description

### FIELD OF THE INVENTION

The present invention concerns the field of electrical equipment, such as power converters, notably configured to be on board of an automotive vehicle such as an electric vehicle (EV) or a hybrid vehicle (HV). The present invention relates to, in particular, an electrical assembly for the electromagnetic shielding of such electrical equipment.

### BACKGROUND OF THE INVENTION

As is known, an electrical equipment, in particular power converters (on-board chargers, DC/DC converters, inverters) for EVs, may comprise several electrical components such as, among others, electronic cards, electrically conductive bars, and capacitive elements, installed in a housing closed by a cover. These electrical components in which currents flow, in particular with high power levels, generate emitted magnetic fields which may perturb the operation of other electrical equipment. Hence, electromagnetic compatibility (EMC) requirements are enforced to ensure that the other electrical equipment are able to function in spite of those electromagnetic disturbances.

A conventional solution, to ensure satisfactory electromagnetic shielding is the use of internal shielding devices, each of the electrical component having its specific shielding device. Electromagnetic shields are thus added in various locations in the electrical equipment to provide shielding for each specific component. However, the addition of such specific shielding devices for each specific component may be costly and lead to more operations when manufacturing the electrical equipment.

An additional conventional solution to meet the EMC requirements is to use an electrically conductive material, in particular a metallic material such as an aluminum, for the housing and the cover. Together they act as a Faraday cage to perform the electromagnetic shielding of the electrical components.

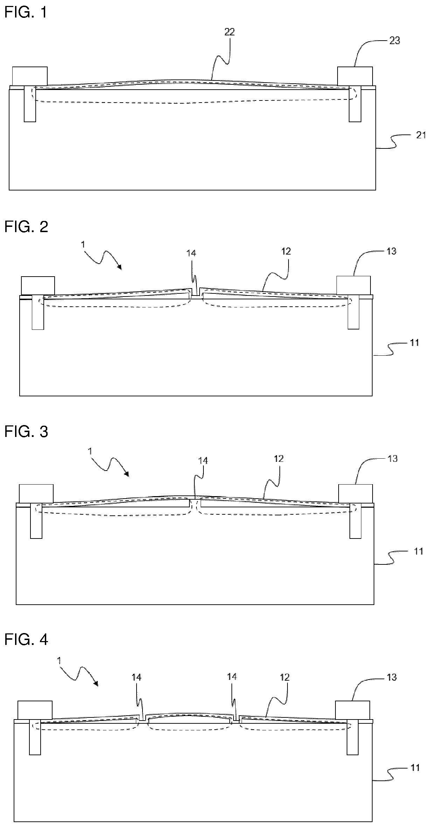

As illustrated in Figure 1, the housing 21 and the cover 22 are attached together through mechanical fixing elements 23, for instance metallic screws or clamps, forming thus an assembly. The mechanical fixing elements 23 should present a low electrical contact resistance, so that to provide electrical connections between the housing and the cover at several locations. It can be noted that outside these electrical connections, the contact between the cover and the housing is not enforced in a controlled manner. Due to surface roughness and/or to the deformation capability of the cover 22 between two mechanical fixing elements 23, the contact may be insufficient to ensure an efficient electrical connection between the two consecutive mechanical fixing elements 23. Then, the emitted magnetic fields induce current (known as eddy current) loops, represented by a dashed line in Figure 1, circulating from the housing to the cover and back to the housing through the mechanical fixing elements. The current loops attenuate in return the emitted magnetic fields, providing an electromagnetic shielding effect.

To enhance the electromagnetic shielding performances, it is possible to reduce the electrical contact resistance of the mechanical fixing elements. This is particularly effective for low emitted frequencies. In addition, it is also possible to increase the number of mechanical fixing elements between the housing and the cover, thus reducing the size of the current loops. In fact, it is of the common knowledge that smaller current loops provide a higher attenuation of the emitted magnetic fields. This latter option is effective for high emitted frequencies. Nevertheless, increasing the number of mechanical fixing elements may not be necessary from the mechanical design point of view and can be cumbersome and costly.

The aim of the invention is therefore to propose an electrical assembly providing an improved electromagnetic performance and/or having fewer mechanical fixing elements.

### SUMMARY OF THE INVENTION

In accordance with the present invention, as defined in claim 1, an electrical assembly configured to form ar electromagnetic shield for an electrical equipment comprising electrical components is provided which can act as a Faraday cage around the electrical components and provide an electromagnetic shielding effect.

The electrical assembly according to the invention presents the substantial advantage of having additional electrical connections other than the mechanical fixing elements, by means of the indents, between the cover and the housing. The indents allow advantageously reducing the size of current loops, thus reducing the resistance of the current loops and improving the electromagnetic shielding performances of the electrical assembly without having to increase the number of mechanical fixing elements. In addition to a reduction of the size of the current loops, the indents increase the total number of loops which also enhances the electromagnetic shielding performances of the electrical assembly. Hence, the present invention allows to increase a compacity of the electrical equipment and to reduce manufacturing costs for a given electromagnetic shielding performance.

According to the invention, the at least one indent consists in at least one indent located between two consecutive mechanical fixing elements of the mechanical fixing elements.

Advantageously, according to a third embodiment of the invention, the at least one indent consists in two indents located between two consecutive mechanical fixing elements of the mechanical fixing elements.

Advantageously, the at least one indent is evenly spaced between the two consecutive mechanical fixing elements.

Advantageously, the electrical assembly comprises a plurality of indents each being located between consecutive pairs of the mechanical fixing elements. Then, according to a fourth embodiment of the invention, each of the at least one indent has a length which is substantially oriented in a transverse direction compared to a direction between the pair of mechanical fixing elements between which said indent is located.

Advantageously, according to a fifth embodiment of the invention, the electrical assembly comprises a plurality of indents distributed substantially in an arc around at least one of the mechanical fixing elements. Then, in a preferred manner, each of the plurality of indents has a length which is substantially oriented in a transverse direction compared to a direction between the center of the corresponding indent and the mechanical fixing element around which said plurality of indents is distributed.

Advantageously, the height of the at least one indent ranges between 100 µm to 500 µm. Advantageously, the electrical equipment comprises the electrical assembly according to the invention, and electrical components located in said housing of said electrical assembly. Advantageously, the electrical equipment is an on-board charger or a DCDC converter or an inverter.

### BRIEF DESCRIPTION OF THE DRAWINGS

The invention will be better understood on reading the description that follows, and by referring to the appended drawings given as non-limiting examples, in which identical references are given to similar objects and in which:
Figure 1 illustrates a schematic view of a conventional assembly having a cover, a housing, and mechanical fixing elements;
Figure 2 illustrates a schematic view of an electrical assembly example according to a first embodiment of the invention;
Figure 3 illustrates a schematic view of an electrical assembly example according to a second embodiment of the invention;
Figure 4 illustrates a schematic view of an electrical assembly example according to a third embodiment of the invention
Figure 5 illustrates a partial schematic view of an electrical assembly example according to a fourth embodiment of the invention;
Figure 6 illustrates a partial schematic view of an electrical assembly example according to a fifth embodiment of the invention;
Figure 7 illustrates a partial schematic view of an electrical assembly example according to a sixth embodiment of the invention;
Figure 8 illustrates a partial schematic view of an electrical assembly example according to a seventh embodiment of the invention.

It should be noted that the figures explain the invention in detail in order to implement the invention, and that the said figures can of course be used to improve the definition of the invention, if applicable.

### DETAILED DESCRIPTION

The invention concerns an electrical assembly configured to form an electromagnetic shield for an electrical equipment comprising electrical components being potential electromagnetic sources. In the description which will be given hereafter the invention will be described principally in the context of an electrical equipment such as an on-board charger, in particular one intended to charge a battery from an electrical grid which is further used to power a rotating electrical machine of a vehicle's motor system. In the case of an on-board charger, several electrical components can be considered as electromagnetic sources, in particular, switching elements are a consequent source of emitted magnetic fields. However, this is a non-limiting application of the invention which concerns any electrical equipment comprising electrical components to be shielded.

With reference to Figures 2 to 8 representing schematically the electrical assembly 1 according to the invention, the electrical assembly 1 comprises a housing 11, a cover 12 closing the housing 11, and mechanical fixing elements 13. The housing 11 and the cover 12 are configured to house the electrical components. Then, the mechanical fixing elements 13, such as screws or clamps or any other mechanical fastening device, are configured to attach the cover together with outer walls of the housing 11.

Moreover, the housing 11, the cover 12, and the mechanical fixing elements 13 are made of an electrically conductive material, in particular a metallic material such as an aluminum, the mechanical fixing elements 13 being adapted to realize an electrical connection between the housing 11 and the cover 12. Hence, the electrical assembly 1 acts as a Faraday cage around the electromagnetic sources and allow to provide an electromagnetic shielding effect. It can be noted that generally the thicker is the housing and/or the cover, the better are electromagnetic shielding performances of the electrical assembly.

The electrical assembly 1 further comprises at least one indent 14 arranged either on a face of the cover 12 facing the housing 11 or on an upper edge of the outer walls of the housing 11 facing the cover 12. The at least one indent 14 is configured to ensure an additional electrical connection between the cover 12 and the housing 11 and is located at a distance from at least one of the mechanical fixing elements 13. Therefore, the additional electrical connection through the at least one indent is especially realized by means of a mechanical pressure originating from the at least one of the mechanical fixing elements.

In particular, the at least one indent may preferably consist in a plurality of indents each being located between consecutive pairs of the mechanical fixing elements. Hence, the electrical connections at the indents are enforced by mechanical pressure originating from the corresponding consecutive pair of mechanical fixing elements.

It is important to note that the height of the indents have been exaggerated in the Figures 2 to 4 for a better understanding of the contact mechanisms. In reality, a possible height for the indents ranges between 100 µm to 500 µm, preferably between 100 µm to 200 µm. The height of the indents is advantageously chosen such that it ensures a minimal value of electrical contact resistance at the indents and takes into account a thermal expansion and a surface roughness of both the housing and the cover. Hence, the height of the indents results mostly from a compromise of having a low electrical contact resistance at the indents while guaranteeing a mechanical integrity of the electrical assembly through service, and in particular of the mechanical fixing elements. For instance, if the mechanical elements are screws, the height of the indents should be low enough so that the torque of the screws remains under control.

Hence, both the mechanical fixing elements and the indents provide electrical connections between the housing and the cover. Notably, it is reminded that outside these electrical connections, the contact between the cover and the housing is not enforced in a controlled manner and due partially to surface roughness and/or to the deformation capability of the cover 22 between two mechanical fixing elements 23, the contact is insufficient to ensure an efficient electrical connection.

Then, the principle of the electromagnetic shielding provided by the electrical assembly is that the magnetic fields emitted by the electromagnetic sources generate currents, known as eddy currents and represented by dashed lines in Figures 2 to 4, circulating in loops within the housing and the cover and passing through the electrical connections provided through the mechanical fixing elements and through the indents. These current loops attenuate in return the emitted magnetic fields, providing an electromagnetic shielding effect. The electromagnetic shielding performance depends in particular on an inductance and a resistance of the current loop. The resistance of the current loop is mainly due to the electrical contact resistance at the level of the electrical connections while the inductance mainly depends on the size of the current loop.

The electrical assembly according to the invention presents the substantial advantage of having additional electrical connections other than the mechanical fixing elements, by means of the indents, between the cover and the housing. The indents allow advantageously reducing the size of the current loops, thus reducing the resistance of the current loops and improving the electromagnetic shielding performances of the electrical assembly without having to increase the number of mechanical fixing elements. In addition to a reduction of the size of the current loops, the indents increase the total number of loops which also enhances the electromagnetic shielding performances of the electrical assembly. Hence, the present invention allows to increase a compacity of the electrical equipment and to reduce manufacturing costs for a given electromagnetic shielding performance.

At high emitted frequencies of the electromagnetic sources, i.e. for emitted frequencies, for instance superior to 100kHz, such as1000kHz, the inductance of the current loop is a more preponderant factor of the electromagnetic shielding performance compared to the resistance of the current loop. It is known that a current loop size reduced by half induces a gain in electromagnetic performances by a factor of 2 for such high emitted frequencies. Hence, the invention allows to provide an improved electromagnetic shielding performance at high emitted frequencies. Moreover, in a general manner, the higher the emitted frequency of the electromagnetic source, the more effective the shielding is.

For low emitted frequencies, for instance inferior to 100kHz, the gain provided by the invention is less substantial than for high emitted frequencies, as the electromagnetic shielding performances depend more on the electrical contact resistance at the electrical connections than on the size of the current loops.

The mechanical fixing elements have especially a lower electrical contact resistance than the indents and thus provide a more effective electrical connection than the indents. For such a configuration with respectively a stronger and a weaker electrical connection, it has been observed that at low emitted frequencies, the electromagnetic shielding performance is driven by the electrical contact resistance of only the stronger electrical connection. The higher the emitted frequency, the more the inductance of the current loop dominates over the electrical contact resistance. Then, the contribution of the weaker electrical connection begins at a value of emitted frequency corresponding to a point where the inductance of the current loop begins to dominate over the electrical contact resistance of the weaker electrical connection. Hence, the contribution on the electromagnetic shielding performance of both the stronger and the weaker electrical connections is particularly effective at high emitted frequency levels.

As stated beforehand, the role of the electrical contact resistance at the electrical connections is important on the electromagnetic shielding performances especially at low emitted frequencies. Furthermore, the electrical contact resistance should correspond to a distance between the electrical connections, because the shorter the distance between the electrical connections, the lower should be the electrical contact resistance to maximize the electromagnetic shielding performances. The electrical contact resistance is preferably similar or close to an electrical resistance of the housing or the cover in themselves for an improved electromagnetic shielding performance.

In particular, the electrical contact resistance of a screw depends among others on the applied mechanical pressure and on dimensions of the screw.

Regarding the indents, the electrical contact resistance depends on several factors, such as the mechanical pressure from the mechanical fixing elements; the height of the indents; the thermal expansion of both the housing and the cover which may partially relax a pressure at the electrical connection point; the tolerances of the housing, of the cover, and of the mechanical fixing elements, potential corrosion or oxidation at the electrical connection point; and a potential loss of mechanical pressure through lifetime.

The electrical contact resistance of the indent connection may advantageously range within 100pohm to 400pohm. Although the preceding values are mostly indicative as the required electrical contact resistance depends on the characteristics of the electrical equipment.

The location of the indents, respectively on the cover or on the housing, is detailed hereunder.

Figure 2 illustrates an example of the electrical assembly 1 according to a first embodiment of the invention where the at least one indent 14 consists in one indent located between two consecutive mechanical fixing elements 13, the indent being a part of the cover 12. In this first embodiment of the invention, such indents may be manufactured by a process of stamping the cover 12.

Figure 3 illustrates an example of the electrical assembly 1 according to a second embodiment of the invention where the at least one indent 14 consists in one indent located between two consecutive mechanical fixing elements, the indent being part of the housing 11. In this second embodiment of the invention, such indents may be manufactured by a process of machining the outer walls of the housing 11 such that to realize the indents having a higher height than the remaining areas of the upper edge of the outer walls of the housing. When using the machining process to form the indents, it is preferable to have an indent height superior to the tolerance of the machining process.

Compared to the stamping process, that could be used when the indents are part of the cover, the machining process of the housing can be more expensive. Nevertheless, the configuration in which the indents are part of the housing should provide a better electromagnetic shielding performance compared to the configuration in which the indents are part of the cover.

In reference to Figures 2 and 3, showing examples of the first and second embodiments of the invention, the electrical assembly comprises one indent located between two consecutive mechanical fixing elements 13. Nevertheless, the number of indents is not limited to one indent only between each two consecutive mechanical fixing elements.

For instance, as illustrated in Figures 4 to 6, the electrical assembly comprises advantageously two indents located between two consecutive mechanical fixing elements. Thereby there are more electrical contacts between the two consecutive mechanical fixing elements, and the number of indents is not too high so that it is still possible to ensure an electrical connection at each indent provided by the two mechanical fixing elements.

From an electromagnetic shielding performance point of view, the configurations with one and two indents, located between each two consecutive mechanical fixing elements, should respectively provide approximately 12dB and 18dB attenuations of the emitted magnetic fields.

Moreover, the one or the two indents located between two consecutive mechanical fixing elements are, in a preferred manner, evenly spaced. Hence, the applied pressure on the indents results from an even addition of the pressures of respectively one and the other one of the two mechanical fixing elements.

Furthermore, several configurations of the indents are possible. The indents should advantageously maximize a contact surface and a contact pressure between the housing and the cover to lower the electrical contact resistance.

In a preferred manner, each of the indents may have a length which is substantially oriented in a substantially transverse direction compared to a direction between the center of each said indent to the nearest mechanical fixing element at a distance from said indent. This configuration is advantageous from the application of the mechanical pressure point of view.

The indents may have, advantageously, a punctual shape, an elongated shape, or a combination of both shapes. The elongated shape provides notably an improved electromagnetic shielding performance compared to the punctual shape.

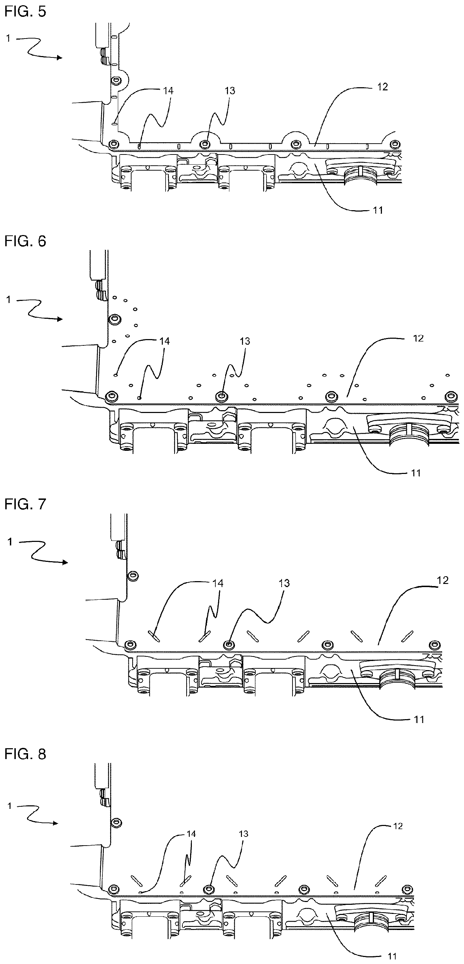

For instance, according to a fourth embodiment of the invention, each of the indents 14 has a length, in a preferred manner, oriented substantially in a transverse direction compared to a direction between the pair of consecutive mechanical fixing elements between which said indent is located. An example of the fourth embodiment is shown in Figure 5. In other words, a preferred direction for the indents is transverse to the outer walls of the housing 11. Moreover, for such a configuration of the indents, the indents preferably present the largest possible length which correspond to a width of the outer walls of the housing 11. Hence, a contact surface between the housing and the cover at the indents is maximized.

Another possible configuration of the indents is illustrated in Figure 6 showing an example of a fifth embodiment of the invention. In the fifth embodiment, the indents 14 are substantially punctual and distributed substantially in an arc around at least one of the mechanical fixing elements 13. Such a configuration should allow to distribute more evenly the mechanical pressure provided by the mechanical fixing elements at the indents. In particular, the mechanical fixing elements 13 are screws.

Moreover, the indents are not necessarily aligned with consecutive mechanical fixing elements 13, but may be deported at a distance from the end of the edges of the cover and/or the housing. This configuration of the indents may be particularly efficient in cases in which the locations along such edges are already occupied for instance by a gasket. Such a configuration is illustrated in Figure 7 presenting an example of a sixth embodiment of the invention.

The indents 14 may also be arranged both at a distance from the end of the edges linking consecutive mechanical fixing elements and along these edges for a given electromagnetic shielding performance to be reached. Such a configuration is illustrated in Figure 8 presenting an example of a seventh embodiment according to the invention. In this configuration, more paths are provided for the current loops inducing a decrease of the inductance and thus improving the electromagnetic shielding performances.

Although embodiments have been described with reference to a number of illustrative embodiments thereof, it should be understood that numerous other embodiments can be devised by those skilled in the art that will fall within the scope of the present invention as defined by the appended claims.

In a nutshell, the present invention thus provides an electrical assembly having an improved electromagnetic shielding performance compared to a conventional solution with a same number of mechanical fixing elements. Or, the present invention provides an electrical assembly having a same electromagnetic shielding performance, with a reduced number of required mechanical fixing elements, which improves a compacity and reduces costs of the electrical equipment. Thus, the present invention is less costly compared to a conventional solution with a higher number of mechanical fixing elements, both from the manufacturing process point of view and from the number of required parts for the mechanical fixing elements. For instance, in the configuration in which the indents are stamped on the cover, the stamping process is a very cost-effective and flexible operation.

In an advantageous manner, the electrical equipment comprises the electrical assembly and electrical components located in said housing of said electrical assembly.

Advantageously, the electrical equipment can in particular be an on-board charger, a DC-DC converter, or an inverter.

## Claims

1. An electrical assembly (1), configured to form an electromagnetic shield for an electrical equipment comprising electrical components, comprising:
- a housing (11);
- a cover (12) closing said housing (11) such that the housing (11) and the cover (12) are configured to house the electrical components;
- mechanical fixing elements (13) configured to attach the cover (12) together with outer walls of the housing (11);
the housing (11), the cover (12), and the mechanical fixing elements (13) being made of an electrically conductive material, the mechanical fixing elements (13) being adapted to realize an electrical connection between the housing (11) and the cover (12),
- at least one indent (14) arranged either on a face of the cover (12) facing the housing (11) or on an upper edge of the outer walls of the housing (11) facing the cover (12), the at least one indent (14) being configured to ensure an additional electrical connection between the cover (12) and the housing (11) and being located at a distance from at least one of the mechanical fixing elements (13)
**characterized in that** the at least one indent (14) is located between two consecutive mechanical fixing elements of the mechanical fixing elements (13).

2. The electrical assembly (1) as claimed in claim 1, wherein the at least one indent (14) consists in one indent located between two consecutive mechanical fixing elements of the mechanical fixing elements (13).

3. The electrical assembly (1) as claimed in claim 1, wherein the at least one indent (14) consists in two indents located between two consecutive mechanical fixing elements of the mechanical fixing elements (13).

4. The electrical assembly (1) as claimed in any of the claims 2 or 3, wherein the at least one indent (14) is evenly spaced between the two consecutive mechanical fixing elements.

5. The electrical assembly (1) as claimed in any of the previous claims, comprising a plurality of indents (14) each being located between consecutive pairs of the mechanical fixing elements (13).

6. The electrical assembly (1) as claimed in the previous claim, wherein each of the at least one indent (14) has a length which is substantially oriented in a transverse direction compared to a direction between the pair of mechanical fixing elements (13) between which said indent (14) is located.

7. The electrical assembly (1) as claimed in claim 1, comprising a plurality of indents (14) distributed substantially in an arc around at least one of the mechanical fixing elements (13).

8. The electrical assembly (1) as claimed in the previous claim, wherein each of the plurality of indents (14) has a length which is substantially oriented in a transverse direction compared to a direction between the center of the corresponding indent and the mechanical fixing element (13) around which said plurality of indents (14) is distributed.

9. The electrical assembly (1) as claimed in any of the previous claims, wherein the height of the at least one indent (14) ranges between 100 µm to 500 µm.

10. Electrical equipment comprising the electrical assembly (1) according to either one of the previous claims, and electrical components located in said housing (11) of said electrical assembly (1).

11. Electrical equipment according to claim 10 being an on-board charger or a DCDC converter or an inverter.

## Patentansprüche

1. Elektrische Baugruppe (1), dazu konfiguriert, eine elektromagnetische Abschirmung für eine elektrische Ausrüstung, umfassend elektrische Komponenten, auszubilden, umfassend:
- ein Gehäuse (11);
- eine Abdeckung (12), die das Gehäuse (11) derart verschließt, dass das Gehäuse (11) und die Abdeckung (12) dazu konfiguriert sind, die elektrischen Komponenten aufzunehmen;
- mechanische Befestigungselemente (13), dazu konfiguriert, die Abdeckung (12) zusammen mit Außenwänden des Gehäuses (11) zu befestigen;
wobei das Gehäuse (11), die Abdeckung (12) und die mechanischen Befestigungselemente (13) aus einem elektrisch leitfähigen Material gefertigt sind, wobei die mechanischen Befestigungselemente (13) dazu angepasst sind, eine elektrische Verbindung zwischen dem Gehäuse (11) und der Abdeckung (12) herzustellen,
- mindestens eine Vertiefung (14), angeordnet entweder an einer dem Gehäuse (11) zugewandten Seite der Abdeckung (12) oder an einer der Abdeckung (12) zugewandten Oberkante der Außenwände des Gehäuses (11), wobei die mindestens eine Vertiefung (14) dazu konfiguriert ist, eine zusätzliche elektrische Verbindung zwischen der Abdeckung (12) und dem Gehäuse (11) sicherzustellen, und von mindestens einem der mechanischen Befestigungselemente (13) beabstandet angeordnet,
**dadurch gekennzeichnet, dass** die mindestens eine Vertiefung (14) zwischen zwei aufeinanderfolgenden mechanischen Befestigungselementen der mechanischen Befestigungselemente (13) angeordnet ist.

2. Elektrische Baugruppe (1) nach Anspruch 1, wobei die mindestens eine Vertiefung (14) aus einer Vertiefung besteht, die zwischen zwei aufeinanderfolgenden mechanischen Befestigungselementen der mechanischen Befestigungselemente (13) angeordnet ist.

3. Elektrische Baugruppe (1) nach Anspruch 1, wobei die mindestens eine Vertiefung (14) aus zwei Vertiefungen besteht, die zwischen zwei aufeinanderfolgenden mechanischen Befestigungselementen der mechanischen Befestigungselemente (13) angeordnet sind.

4. Elektrische Baugruppe (1) nach einem der Ansprüche 2 und 3, wobei die mindestens eine Vertiefung (14) zwischen den zwei aufeinanderfolgenden mechanischen Befestigungselementen gleichmäßig beabstandet ist.

5. Elektrische Baugruppe (1) nach einem der vorhergehenden Ansprüche, umfassend eine Vielzahl von Vertiefungen (14), die jeweils zwischen aufeinanderfolgenden Paaren der mechanischen Befestigungselemente (13) angeordnet sind.

6. Elektrische Baugruppe (1) nach dem vorhergehenden Anspruch, wobei jede der mindestens einen Vertiefung (14) eine Länge aufweist, die im Vergleich zu einer Richtung zwischen dem Paar mechanischer Befestigungselemente (13), zwischen denen die Vertiefung (14) angeordnet ist, im Wesentlichen in einer Querrichtung ausgerichtet ist.

7. Elektrische Baugruppe (1) nach Anspruch 1, umfassend eine Vielzahl von Vertiefungen (14), die im Wesentlichen in einem Bogen um mindestens eines der mechanischen Befestigungselemente (13) herum verteilt sind.

8. Elektrische Baugruppe (1) nach dem vorhergehenden Anspruch, wobei jede der Vielzahl von Vertiefungen (14) eine Länge aufweist, die im Vergleich zu einer Richtung zwischen der Mitte der entsprechenden Vertiefung und dem mechanischen Befestigungselement (13), um welches herum die Vielzahl von Vertiefungen (14) verteilt ist, im Wesentlichen in einer Querrichtung ausgerichtet ist.

9. Elektrische Baugruppe (1) nach einem der vorhergehenden Ansprüche, wobei die Höhe der mindestens einen Vertiefung (14) im Bereich zwischen 100 µm und 500 µm liegt.

10. Elektrische Ausrüstung, umfassend die elektrische Baugruppe (1) nach einem der vorhergehenden Ansprüche und elektrische Komponenten, die in dem Gehäuse (11) der elektrischen Baugruppe (1) angeordnet sind.

11. Elektrische Ausrüstung nach Anspruch 10, bei der es sich um ein Bordladegerät oder einen Gleichstrom-Gleichstrom-Wandler oder um einen Wechselrichter handelt.

## Revendications

1. Ensemble électrique (1), configuré pour former un blindage électromagnétique pour un équipement électrique comprenant des composants électriques, comprenant :
- un logement (11) ;
- un couvercle (12) fermant ledit logement (11) de telle sorte que le logement (11) et le couvercle (12) soient configurés pour loger les composants électriques ;
- des éléments de fixation mécaniques (13) configurés pour attacher le couvercle (12) conjointement avec des parois externes du logement (11) ;
le logement (11), le couvercle (12), et les éléments de fixation mécaniques (13) étant constitués d'un matériau électriquement conducteur, les éléments de fixation mécaniques (13) étant conçus pour réaliser une connexion électrique entre le logement (11) et le couvercle (12),
- au moins une indentation (14) agencée soit sur une face du couvercle (12) faisant face au logement (11), soit sur un bord supérieur des parois extérieures du logement (11) faisant face au couvercle (12), l'au moins une indentation (14) étant configurée pour assurer une connexion électrique supplémentaire entre le couvercle (12) et le logement (11) et étant située à distance d'au moins l'un des éléments de fixation mécaniques (13)
**caractérisé en ce que** ladite au moins une indentation (14) est située entre deux éléments de fixation mécaniques consécutifs des éléments de fixation mécaniques (13).

2. Ensemble électrique (1) selon la revendication 1, dans lequel l'au moins une indentation (14) consiste en une indentation située entre deux éléments de fixation mécaniques consécutifs des éléments de fixation mécaniques (13).

3. Ensemble électrique (1) selon la revendication 1, dans lequel l'au moins une indentation (14) consiste en deux indentations situées entre deux éléments de fixation mécaniques consécutifs des éléments de fixation mécaniques (13).

4. Ensemble électrique (1) selon la revendication 2 ou la revendication 3, dans lequel l'au moins une indentation (14) consiste en deux indentations situées entre deux éléments de fixation mécaniques consécutifs des éléments de fixation mécaniques (13).

5. Ensemble électrique (1) selon l'une quelconque des revendications précédentes, comprenant une pluralité d'indentations (14), étant chacune située entre des paires consécutives des éléments de fixation mécaniques (13) .

6. Ensemble électrique (1) selon la revendication précédente, dans lequel chaque indentation de l'au moins une indentation (14) a une longueur qui est substantiellement orientée dans une direction transversale par rapport à une direction entre la paire d'éléments de fixation mécaniques (13) entre lesquels ladite indentation (14) est située.

7. Ensemble électrique (1) selon la revendication 1, comprenant une pluralité d'indentations (14) réparties substantiellement en arc autour d'au moins l'un des éléments de fixation mécaniques (13).

8. Ensemble électrique (1) selon la revendication précédente, dans lequel chaque indentation de la pluralité d'indentations (14) a une longueur qui est substantiellement orientée dans une direction transversale par rapport à une direction entre le centre de l'indentation correspondante et l'élément de fixation mécanique (13) autour duquel ladite pluralité d'indentations (14) est répartie.

9. Ensemble électrique (1) selon l'une quelconque des revendications précédentes, dans lequel la hauteur de l'au moins une indentation (14) est comprise entre 100 µm et 500 µm.

10. Équipement électrique comprenant l'ensemble électrique (1) selon l'une quelconque des revendications précédentes, et des composants électriques situés dans ledit logement (11) dudit ensemble électrique (1).

11. Équipement électrique selon la revendication 10 étant un chargeur embarqué ou un convertisseur CC/CC de charge embarqué ou un onduleur.
